# EUROPÄISCHE PATENTSCHRIFT

(11) **EP 2 122 701 B1**
(45) Veröffentlichungstag und Bekanntmachung des Hinweises auf die Patenterteilung: **10.10.2012**
(21) Anmeldenummer: 08708531.2
(22) Anmeldetag: 31.01.2008
(51) Int. Cl.: H01L 41/083, H01L 41/24

(54) **VIELSCHICHTBAUELEMENT SOWIE VERFAHREN ZUR HERSTELLUNG EINES VIELSCHICHTBAUELEMENTS**
MULTI-LAYER COMPONENT AND METHOD FOR PRODUCING A MULTI-LAYER COMPONENT
ÉLÉMENT MULTICOUCHE ET PROCÉDÉ DE FABRICATION ASSOCIÉ

(30) Priorität: 02.02.2007 DE 102007005341
(43) Veröffentlichungstag der Anmeldung: 25.11.2009
(73) Patentinhaber: Epcos AG, 81669 München (DE)
(72) Erfinder: KÜGERL, Georg, 8552 Eibiswald (AT); BAUER, Wolfgang, 8551 Wies (AT); REINISCH, Manfred, 8522 Gr. St. Florian (AT); ALDRIAN, Franz, 8541 Hollenegg (AT); OTTLINGER, Marion, 8530 Deutschlandsberg (AT)
(74) Vertreter: Epping, Wilhelm
(86) Internationale Anmeldenummer: PCT/EP2008/051220
(87) Internationale Veröffentlichungsnummer: WO 2008/092932

(56) Entgegenhaltungen:
- EP-A- 0 247 540
- EP-A1- 1 764 844
- WO-A1-2007/012484
- DE-A1- 10 307 825
- DE-A1-102004 007 999
- DE-A1-102004 031 402
- DE-A1-102004 050 803
- DE-A1-102005 015 112

## Beschreibung

Es wird ein Verfahren zur Herstellung eines Vielschichtbauelements, insbesondere ein Verfahren, bei dem Vielschichtsegmente miteinander verpresst werden, beschrieben. Auch wird ein Vielschichtbauelement mit Sollbruchbereichen beschrieben.

Aus DE 102 34 787 C1 ist ein Verfahren zur Herstellung eines Vielschichtaktors bekannt. Im Aktorgefüge sind Mikrostörungen gezielt eingebaut, welche beim Polarisieren des Aktors nach innen wachsen.

Weitere Herstellungsverfahren sind aus EP 0 247 540 A2 und DE 10 2004 007 999 A1 bekannt.

Aus WO 2004/077583 oder DE 103 07825 A1 ist ein elektrisches Vielschichtbauelement mit entlang einer Längsachse angeordneten Keramikschichten bekannt, wobei wenigstens an einer Stelle der Längsachse zwischen keramischen Schichten eine keramische Sollbruchschicht angeordnet ist. Diese weist gegenüber Zugspannungen in Längsrichtung eine geringere Stabilität auf als die keramischen Schichten.

Eine zu lösende Aufgabe besteht darin, ein elektrisches Vielschichtbauelement bzw. ein Verfahren zur Herstellung eines solchen anzugeben, welches bei wiederholten mechanischen Belastungen funktionstüchtig bleibt.

Anspruch 1 definiert ein erfindungsgemäßes Verfahren zur Herstellung eines keramischen Vielschichtbauelements, bei dem mehrere keramische Vielschichtsegmente miteinander verpresst werden. Die keramischen Vielschichtsegemente weisen jeweils mehrere miteinander verpresste keramische Schichten auf.

Als Vielschichtsegment wird ein Stapel von mindestens zwei keramischen Schichten mit beliebiger äußerer Umrissform verstanden. Ein Vielschichtbauelement ergibt sich aus einem Stapel von übereinander angeordneten und miteinander verpressten Vielschichtsegmenten.

Anhand der Auswahl einer bestimmten, geringen Anzahl von verpressten keramischen Schichten werden dünne Vielschichtsegmente bereitgestellt, deren äußere Formgebung, beispielsweise mittels eines Schneidwerkzeuges, ohne Beschädigung der Vielschichtsegmente und gegebenenfalls unter Anwendung eines weniger energisch bzw. weniger kräftig betriebenen Schneidwerkzeugs stattfinden kann. Da mehrere so geformte Vielschichtsegmente miteinander verpresst werden, kann ein ganzes Vielschichtbauelement, beispielsweise ein piezoelektrisches Vielschichtbauelement, mit der erwünschten äußeren Umrissform und Höhe geschaffen werden. Die Umrissform ist dabei zumindest teilweise gekrümmt, kreisförmig oder ovalförmig.

Gegenüber Vielschichtbauelementen, welche erst nach dem Erreichen ihrer endgültigen Bauhöhe zurechtgeschnitten werden und einer Beschädigungsgefahr unterliegen, weil das hierzu verwendete Schneidmittel mit großem Kraftaufwand durch viel Material in einem Zug getrieben werden muss, besteht somit ein entscheidender Vorteil.

Auch gegenüber Vielschichtbauelementen, bei denen einzelne bereits zurechtgeschnittene keramische Schichten übereinander gestapelt werden, besteht der Vorteil der Einsparung dieser Verstapelung jeder einzelnen bereits vereinzelten keramischen Schicht mit einer anderen keramischen Schicht.

Auch ist die Handhabung, beispielsweise beim Transport, von Vielschichtsegmenten gegenüber einzelnen keramischen Schichten leichter. Die Wahrscheinlichkeit von Prozessfehlern, die sich bei jeder Vereinzelung einer keramischen Schicht anhäufen können, kann minimiert werden.

Die Herstellungszeit für ein Vielschichtbauelement wird vorteilhafterweise deutlich gekürzt, da nicht jede einzelne keramische Schicht auf eine andere keramische Schicht gelegt werden muss.

Das Herstellungsverfahren bietet den Vorteil, dass Vielschichtbauelemente in beliebiger Bauhöhe geschaffen werden können. Somit können solche geschaffen werden, die bestimmte, bei beengten Platzverhältnissen geltende Kriterien beim Einbau in eine das Vielschichtbauelement einsetzende Vorrichtung erfüllen.

Ein weiterer Vorteil besteht darin, dass Vielschichtbauelemente bereits in einem ungesinterten, d.h. grünen Zustand mit einer gewünschten äußeren Umrissform geschaffen werden können. Somit entfällt beispielsweise die Notwendigkeit, einem gesinterten Bauelement mittels eines kosten- und zeitintensiven Schleifvorgangs die gewünschte Umfangsgeometrie zu geben. Wo dieser Schritt entfällt können beispielsweise Außenkontakte gleich bzw. direkt auf das gesinterte Bauelement aufgebracht werden. Es ergibt sich also ein noch weiterer positiver Effekt.

Vorzugsweise werden mehrere keramische Folien miteinander als Vorprodukt zu einem Folienstapel verpresst, wobei die keramischen Folien vorzugsweise ein organisches Bindemittel enthalten, womit das Verpressen bzw. die Handhabbarkeit der Folien, beispielsweise im Transport, erleichtert wird.

Der keramische Folienstapel bzw. die verstapelten keramischen Folien sind im Verhältnis zur Querschnittsfläche eines später herauszutrennenden keramischen Vielschichtsegments großflächig, d.h., der keramische Folienstapel als Vorprodukt umfasst vorzugsweise ein Vielfaches der Fläche der später herauszutrennenden, als Nachprodukt zu bezeichnenden Vielschichtsegmente.

Es stellt sich als besonders günstig heraus, wenn die Temperatur, bei der die keramischen Folien miteinander verpresst werden, niedriger ist, als die Temperatur, bei der die Vielschichtsegmente miteinander verpresst werden. Damit wird eine Anbindung der Vielschichtsegmente aneinander derart erreicht, dass zumindest im fertig gesinterten Bauelement der Grenzbereich zwischen den Vielschichtsegmenten eine gegenüber Zugbelastungen reduzierte Festigkeit aufweist. Im Vergleich sind die keramischen Schichten eines einzelnen Vielschichtsegments fester miteinander verbunden.

Gemäß einer bevorzugten Ausführungsform des Herstellungsverfahrens wird die Bindewirkung des organischen Bindemittels während des Verpressens der Vielschichtsegmente im Vergleich zur Bindewirkung während des Verpressens der keramischen Folien gezielt unterschiedlich eingestellt. Vorzugsweise wird dabei ein Bindemittel gewählt, dessen Wirkung von mehreren Prozessparametern, wie beispielsweise Temperatur, Presskraft der Vielschichtsegmente aufeinander, Dauer der genannten Presskraft, Atmosphäre bzw. Zusammensetzung der Atmosphäre, in der die Folien und/oder die Vielschichtsegmente miteinander verpresst werden, abhängig ist. Die gezielte Änderung der Wirkung des Bindemittels hat den Vorteil, dass die Anbindung bzw. Haftung der Vielschichtsegmente aneinander gesteuert werden kann.

Während des Verpressens der Vielschichtsegmente sind die darin enthaltenen keramischen Schichten im grünen Zustand. Das bedeutet, dass die Vielschichtsegmente nicht erst separat gesintert sein müssen.

Die Temperatur, bei der die keramischen Folien miteinander verpresst werden, weicht vorzugsweise höchstens um 25% von der Raumtemperatur ab. Dabei soll die Temperatur, bei der die Vielschichtsegmente miteinander verpresst werden, vorzugsweise zwischen 75°C und 95°C liegen.

Es wird bevorzugt, dass durch Einstellung der Temperatur, bei der die Vielschichtsegmente miteinander verpresst werden, die Zugfestigkeit des Grenzbereichs zwischen den Vielschichtsegmenten bestimmt wird.

Auch durch Einstellung der beim Verpressen der Vielschichtsegmente angewandten Presskraft kann die Zugfestigkeit des Grenzbereichs zwischen den Vielschichtsegmenten bestimmt werden.

Zusätzlich oder alternativ kann durch Einstellung der Dauer des Verpressens der Vielschichtsegmente die Zugfestigkeit des Grenzbereichs zwischen den Vielschichtsegmenten bestimmt werden.

Durch Einstellung der oben genannten Prozessparameter Temperatur, Presskraft und/oder Dauer der Presskraft wird eine Zugfestigkeit für den Grenzbereich zwischen zwei Vielschichtsegmenten bestimmt, die ihm eine Funktion als Sollbruchbereich verleiht. Je nach Anwendung des Vielschichtbauelements kann somit ein Sollbruchbereich geschaffen werden, der bei bestimmten mechanischen Belastungen anspricht bzw. einen Riss bildet. Der Sollbruchbereich bildet damit eine gezielte mechanische Schwachstelle im Vielschichtbauelement.

Ein Sollbruchbereich, der mittels des in diesem Dokument beschriebenen Herstellungsverfahrens im Grenzbereich zwischen zwei Vielschichtsegmenten eines Vielschichtbauelements entsteht, ermöglicht bei bestimmten Zugbelastungen einen kontrollierten Riss ins Innere des Vielschichtbauelements. Die Rissbildung erfolgt dabei im Wesentlichen parallel zur Ebene der keramischen Schichten.

Die Vielschichtsegmente werden vorzugsweise mittels eines Schneidwerkzeuges vom Vorprodukt Folienstapel heraus- bzw. abgetrennt. Dabei können sie mit beliebiger äußerer Umrissform herausgetrennt werden. Somit wird das Heraustrennen von Vielschichtsegmenten mit insbesondere kreisförmigen oder ovalförmigen oder zumindest nahezu kreisförmigen oder ovalförmigen Umrissen erreicht, wodurch Vielschichtbauelemente mit solchen Umrissformen für hohe Qualitäts- bzw. Stabilitätsansprüche geschaffen werden können.

Prozesstechnisch zeigt es sich als besonders vorteilhaft, wenn das Schneidwerkzeug die abgetrennten Vielschichtsegmente direkt weitertransportiert, beispielsweise in eine weitere Herstellungseinheit zur weiteren Verarbeitung einführt.

Die Vielschichtsegmente werden nach einer Ausführungsform zum Verpressen in eine Kaverne weitertransportiert. Mittels eines solchen Verfahrens wird die Notwendigkeit eines für den Transport eigens verwendeten Beförderungsmittels, beispielsweise eines Transportbands oder eines Greifmittels, eingespart.

Wird als Schneidwerkzeug ein Stanzwerkzeug verwendet, kann das Heraustrennen der Vielschichtsegmente vom Folienstapel besonders schnell erfolgen. Da der Folienstapel in einer relativ geringen Dicke vorliegt, kann das Stanzwerkzeug die ebenfalls relativ dünnen Vielschichtsegmente mit einer beliebigen Querschnittsform ausstanzen, ohne sie dabei zu beschädigen.

Vorzugsweise werden in einem wiederholten Vorgang jeweils zwei benachbarte Vielschichtsegmente miteinander verpresst. Für ein Vielschichtbauelement, welches beispielsweise 50 Vielschichtsegmente aufweist, werden also 49 Verpressvorgänge jeweils mit zwei benachbarten Vielschichtsegmenten ausgeführt. Die Anzahl der Verpressvorgänge ist somit um eins weniger, als die Anzahl der Vielschichtsegmente im fertigen Vielschichtbauelement.

Gemäß einer Ausführungsform des Verfahrens werden die Vielschichtsegmente dadurch miteinander verpresst, dass ein Stanzwerkzeug auf eine Stirnfläche eines Vielschichtsegments drückt, welches zuletzt in die Kaverne eingeführt wurde. Das Vielschichtsegment, auf das das Stanzwerkzeug drückt, befindet sich stets in der obersten Position in der Kaverne.

Die Vielschichtsegmente werden gemäß einer weiteren Ausführungsform des Herstellungsverfahrens unter zusätzlicher Verwendung eines Pressstifts, welches gegen das unterste in der Kaverne befindliche Vielschichtsegment in Richtung des Stanzwerkzeugs drückt, miteinander verpresst.

Zur Herstellung der Vielschichtsegmente können keramische Folien mit aufgedruckten Metallisierungen verwendet werden. Diese können später als Elektroden bzw. Elektrodenschichten des fertig hergestellten Vielschichtbauelements dienen.

Ein Pressverzug, der zum Abknicken von gegebenenfalls vorhandenen Innenelektroden zumindest an den Enden des Vielschichtbauelements führen könnte, wird mittels des Herstellungsverfahrens stark minimiert, weil einzelne Vielschichtsegmente miteinander verpresst werden und nicht ein ganzes Vielschichtbauelement größerer Höhe. Somit wird ein konvexes bzw. konkaves Biegen der Innenelektroden (bezogen auf die durch das Vielschichtbauelement in vertikaler Richtung verlaufende Achse) minimiert. Insgesamt wird ein Vielschichtbauelement mit hoher Symmetrie geschaffen.

Mittels des angegebenen Herstellungsverfahrens kann ein piezoelektrisches Vielschichtbauelement geschaffen werden. Hierzu enthalten die keramischen Schichten vorzugsweise eine PZT (Blei-Zirkonat-Titanat) Keramik. Die keramischen Folien können ein Bindemittel enthalten, welches während eines Entbinderungsprozesses vor einem Sintervorgang des Vielschichtbauelements ausgebrannt wird.

Anspruch 14 definiert außerdem erfindungsgemäßes ein Vielschichtbauelement mit einem Stapel von übereinander angeordneten keramischen Schichten und Elektrodenschichten, wobei ein parallel zu den keramischen Schichten verlaufender Sollbruchbereich reduzierter Zugfestigkeit zwischen benachbarten keramischen Schichten lokalisiert ist und teilweise in diese eindringt. Benachbarte keramische Schichten weisen somit einen Teil des Sollbruchbereichs auf.

Das Vielschichtbauelement weist dabei mehrere miteinander verpresste, einzelne keramische Schichten aufweisende Vielschichtsegmente auf, die miteinander versintert sind. Somit verläuft der Sollbruchbereich zwischen benachbarten keramischen Schichten und dringt teilweise in diese hinein bzw. ist teilweise in den keramischen Schichten enthalten. Benachbarte, zu verschiedenen Vielschichtsegmenten gehörende keramische Schichten bilden dabei Teile des Sollbruchbereichs.

Das Vielschichtbauelement bzw. die von ihm umfassten Vielschichtsegmente sind vorzugsweise ein Erzeugnis des in diesem Dokument beschriebenen Herstellungsverfahrens in allen seinen möglichen Ausführungsformen.

Der Sollbruchbereich weist gemäß einer Ausführungsform eine Porosität auf, die höher ist, als die durchschnittliche Porosität der keramischen Schichten im gesamten Vielschichtbauelement.

Es können rand- bzw. stirnseitige keramische Schichten benachbarter Vielschichtsegmente aneinander angrenzende bzw. ineinander übergehende Bereiche aufweisen, die weniger zugfest bzw. poröser sind, als die keramischen Schichten, die der Grenze zwischen den Vielschichtsegmenten abgewandt sind. Die erhöhte Porosität kann auch als geringere Packungsdichte der Keramikkörner im entsprechenden Bereich verstanden werden.

Der Sollbruchbereich zwischen den Vielschichtsegmenten bildet einen ins Innere des Vielschichtbauelements verlaufenden Riss, wenn das Vielschichtbauelement bestimmten mechanischen Belastungen ausgesetzt wird. Ist zwischen den Vielschichtsegmenten jeweils eine Elektrodenschicht bzw. flächige Metallisierung angeordnet, so verläuft der Riss entlang bzw. parallel zu der Elektrode bzw. durch die Elektrodenschicht und verbindet somit nicht zwei übereinander angeordnete Elektroden. Ein elektrischer Kurzschluss, der zum Ausfall des Vielschichtbauelements führen würde, kann somit vermieden werden.

Das Vielschichtbauelement weist vorzugsweise mehrere über die Höhe des Vielschichtbauelements in regelmäßigen Abständen verteilte Sollbruchbereiche auf. Die Abstände, d.h. der Raum zwischen jeweils zwei benachbarten Sollbruchbereichen, umfasst mehrere keramischen Schichten und Elektrodenschichten, zwischen denen kein Sollbruchbereich bereitgestellt ist.

Die beschriebenen Gegenstände werden anhand der folgenden Ausführungsbeispiele und Figuren näher beschrieben. Dabei zeigt:
- Figur 1: ein Vielschichtbauelement mit einer Sollbruchstelle in einer ersten Anordnung,
- Figur 2: ein Vielschichtbauelement mit einer Sollbruchstelle in einer zweiten Anordnung,
- Figur 3: eine Querschnittsdarstellung eines Vielschichtbauelements,
- Figur 4: eine perspektivische Ansicht eines Teils eines eine Kaverne umfassenden, im Wesentlichen massiven Blocks mit einem teilweise eingeführten Stanzwerkzeug,
- Figur 5: eine Draufsicht auf einen eine Kaverne umfassenden, im Wesentlichen massiven Block,
- Figur 6: eine Seitenansicht eines eine Kaverne umfassenden, im Wesentlichen massiven Blocks mit einem teilweise eingeführten Stanzwerkzeug.

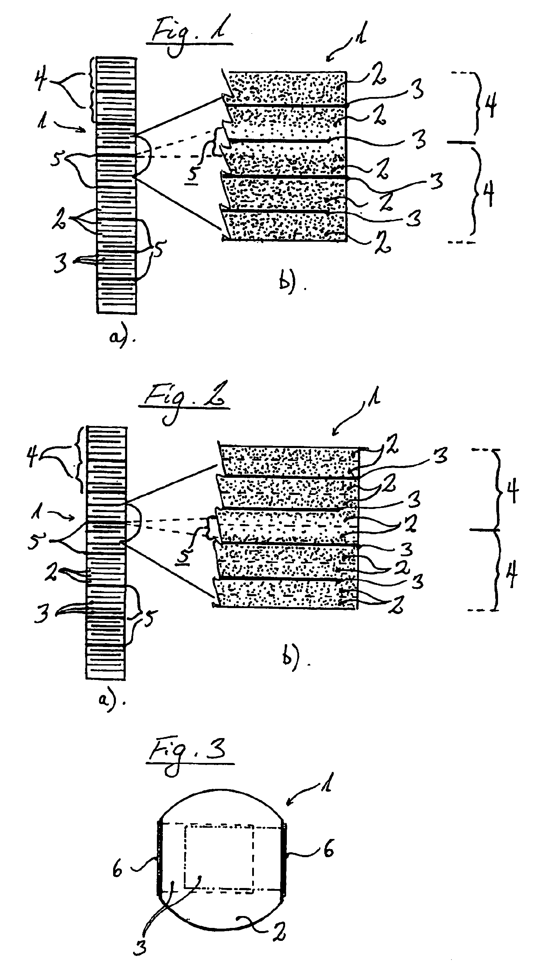

Figur 1a zeigt ein Vielschichtbauelement 1 mit abwechselnd übereinander angeordneten keramischen Schichten 2 und Elektrodenschichten 3. Figur 1b zeigt einen vergrößerten Ausschnitt aus Figur 1a. Das Vielschichtbauelement weist mehrere Vielschichtsegmente 4 auf, welche jeweils mehrere keramische Schichten und Elektrodenschichten aufweisen. Zwischen jeweils zwei benachbarten Vielschichtsegmenten 4 ist ein Sollbruchbereich 5 bereitgestellt, der als Bereich verringerter Zugfestigkeit im Vergleich zu den Grenzflächen zwischen weiteren keramischen Schichten tiefer im Inneren eines jeden Vielschichtsegments 4 ausgeführt ist. Der Sollbruchbereich 5 ist im Grenzbereich zwischen zwei benachbarten Vielschichtsegmenten enthalten und geht mit seiner verringerten mechanischen Zugfestigkeit in eine untersten und obersten keramischen Schicht benachbarter Vielschichtsegmente über.

Der Sollbruchbereich 5 mittels des Herstellungsverfahrens des Vielschichtbauelements als Bereich verringerter Porosität im Vergleich zur Porosität weiterer keramischer Schichten im Inneren eines jeden Vielschichtsegments 4 realisiert werden. Die erhöhte Porosität im Grenzbereich zwischen zwei Vielschichtsegmenten 4 kann durch Einstellung der Kombination folgender Parameter bestimmt werden:
- Temperatur und / oder Presskraft sowie Dauer der Presskraft, bei der die keramischen Folien zum Vorprodukt Folienstapel verpresst werden,
- Auswahl eines für die keramischen Folien verwendeten Bindemittels bezogen auf seine Bindewirkung in Abhängigkeit der zuvor genannten Parameter,
- Temperatur und / oder Presskraft sowie Dauer der Presskraft, bei der Vielschichtsegmente miteinander verpresst werden.

Figur 1 zeigt insbesondere, wie der Grenzbereich zwischen zwei Vielschichtsegmenten 4 ausgeführt sein kann. Der Grenzbereich verringerter Zugfestigkeit verläuft nach einer Ausführungsform zwischen zwei rand- bzw. stirnseitigen keramischen Schichten 2 benachbarter Vielschichtsegmente 4, wobei eine dieser keramischen Schichten mit einer aufgedruckten Innenelektrodenschicht 3 versehen ist. Das bedeutet, dass die Sollbruchstelle 5 durch die Innenelektrodenschicht 2 verläuft bzw. eine durch bestimmte Zugbelastungen verursachte Rissbildung durch die Innenelektrodenschicht verläuft.

Figur 2a zeigt ein Vielschichtbauelement 1 mit abwechselnd übereinander angeordneten keramischen Schichten 2 und Elektrodenschichten 3. Figur 2b zeigt einen vergrößerten Ausschnitt aus Figur 1a. Hinsichtlich seiner Zusammensetzung entspricht diese Ausführung des Vielschichtbauelements derjenigen der Figur 1. Der Sollbruchbereich 5 an zwei benachbarten Vielschichtsegmenten ist hier jedoch anders ausgeführt. Er geht in zwei rand- bzw. stirnseitige und benachbarte keramische Schichten 2 benachbarter Vielschichtsegmente 4 über, wobei zwischen diesen keramischen Schichten keine Elektrodenschicht 3 vorhanden ist. Eine solche Konstruktion kann beispielsweise dadurch erreicht werden, dass die aus einem Folienstapel herausgetrennten Vielschichtsegmente mit unterschiedlicher Orientierung zum Verpressen übereinander gestapelt werden. Das bedeutet, dass beispielsweise zwei benachbarte und miteinander verpresste Vielschichtsegmente 4 einander zugewandte Stirnflächen aufweisen können, die frei von Innenelektrodenschichten 3 sind.

Figur 3 zeigt als Draufsicht ein Vielschichtbauelement 1 mit einer bevorzugten Umrissform. Das Vielschichtbauelement bzw. jedes Vielschichtsegment 4 des Vielschichtbauelements ist dabei im Querschnitt kreisförmig mit abgeflachten Abschnitten. An den abgeflachten Abschnitten können besonders günstig Außenelektroden 6 aufgebracht werden bzw. angeordnet sein, die jeweils mit einem Satz von übereinander angeordneten Innenelektrodenschichten 3 desselben elektrischen Pols kontaktiert sind.

Das Vielschichtbauelement bzw. seine Vielschichtsegmente haben vorzugsweise einen Durchmesser von 8 bis 10 mm; die abgeflachten Abschnitte jeweils eine Länge von 2 bis 4 mm.

Es wird zur Herstellung des Vielschichtbauelements vorzugsweise folgender Vorgang gewählt.

Bei der Herstellung eines Vielschichtbauelements wird gemäß einer Ausführungsform ein Keramikpulver mit piezoelektrischen Eigenschaften nach Zugabe eines geeigneten Binder- und Dispergatorsystems in Form eines Schlickers zu Folien verarbeitet.

Die Folien werden nach gewünschtem Design mit einer Elektrodenpaste derart bedruckt, insbesondere siebbedruckt, dass eine Isolationszone an den abgeflachten Abschnitten des Vielschichtbauelements bereitgestellt wird. Die Isolationszone umfasst einen nahezu feldfreien Bereich, wo benachbarte Innenelektroden sich nicht überlappen. Jede Folie wird erneut bedruckt, wobei die Bedruckung benachbarter Folien eines Folienstapels mit einem Versatz erfolgt.
Anschließend erfolgt das Laminieren bzw. Aufstapeln von vorzugsweise 25 bis 50 Folien. Mittels eines Verpressvorgangs bei etwa Raumtemperatur unter 100 metrischen Tonnen Gewicht bezogen auf eine Fläche von 105 x 105 mm² werden sie auf eine Höhe von 1 bis 2 mm heruntergepresst. Die dielektrische Dicke einer jeden keramischen Folie beträgt dann ca. 100 bis 120 µm. Die geringe Höhe des Folienstaples ermöglicht das Heraustrennen beliebiger Vielschichtsegmente, vorzugsweise mit runder, ovaler oder achteckiger Querschnittsform aus dem Folienstapel.

Aus dem verpressten Folienstapel werden mit einem Stempel Vielschichtsegmente mit der gewünschten Querschnittsform ausgestanzt. Der Stempel bzw. das Stanzwerkzeug umfasst dabei einen scharfen, hervorstehenden Rand zum Ausstanzen von Vielschichtsegmenten; weiter innen weist er einen flächigen Bereich auf, der auf die Vielschichtsegmentfläche drückt und sie aus dem Folienstapel löst.

Vorteilhafterweise sind die herausgetrennten Vielschichtsegmente im Gegensatz zu einzelnen keramischen Schichten (welche sich jeweils aus einer einzigen keramischen Folie ergeben) im Fertigungsprozess des Vielschichtbauelements sehr viel leichter handzuhaben. Sie können beispielsweise besser gegriffen und transportiert werden. Dabei wird auch das Beschädigungsrisiko dieser Vielschichtsegmente reduziert. Die Wirksamkeit dieser Vorteile kommt insbesondere dann zum Vorschein, wenn die Querschnittsfläche des herausgetrennten Vielschichtsegments 20 mm² oder kleiner beträgt.

Die aus dem Folienstapel bzw. aus den Folienstapeln herausgetrennten Vielschichtsegmente geringer Höhe werden vorzugsweise mittels des Stanzwerkzeugs in einer Kaverne eingestapelt. Ein Vielschichtsegment wird auf ein bereits in der Kaverne befindliches Vielschichtsegment bzw. Teilvielschichtbauelement mit 1500 N Kraft bei etwa 85° C aufgepresst. Der Vorgang wird wiederholt bis ein piezoelektrisches Vielschichtbauelement mit einer beliebigen Höhe, vorzugsweise zwischen 70 und 100 mm, geschaffen wird.

Hier wird der Vorteil der Verpressung kleiner Volumina deutlich, da die Streuung der Presskraft bezogen auf eine kleine Fläche verhältnismäßig klein ist. Sich einstellende Reibungskräfte an den inneren Wänden der Kaverne sind geringer als bei größeren Vielschichtbauelementen, beispielsweise solche, welche einen und eine Höhe von 10 bis 1000 mm aufweisen. Somit können Vielschichtbauelemente äußerst hoher Symmetrie geschaffen werden; Pressverzüge eines fertigen Vielschichtbauelements können nicht mehr festgestellt werden. Darüber hinaus wird durch das Herstellungsverfahren dafür gesorgt, dass gegebenenfalls im Vielschichtbauelement vorhandene Innenelektroden durch keinen oder minimalem Verzug bzw. Biegen betroffen sind. Mangels des o. g. Pressverzuges werden darüber hinaus keine eingeknickte oder am Rande des Vielschichtbauelements abgeknickte Innenelektrodenteile festgestellt.

Vorzugsweise werden als Kriterien zur Einstellung der absoluten Bruchkraft an den Nahtstellen zwischen den Vielschichtsegmenten die angewandte Presskraft, Temperatur oder Haltezeit bei einem Verpressvorgang verwendet.

Ein mittels des Verpressens von Vielschichtsegmenten bereitgestelltes, noch grünes Vielschichtbauelement kann anschließend entbindert und gesintert werden. Danach können Außenkontakte auf die Seitenflächen des Vielschichtbauelements aufgebracht werden.

Messungen an den mittels des Verpressens von Vielschichtsegmenten bereitgestellten Vielschichtbauelementen zeigen einen Nahtbereich zwischen benachbarten Vielschichtsegmenten mit einer geringeren Festigkeit als die in den Vielschichtsegmenten liegenden Verbindungen zwischen einzelnen keramischen Schichten. Als Vorteil dieses Effekts wurde erkannt, dass das Vielschichtbauelement aufgrund der weniger festen Nahtbereiche eine oder mehrere Sollbruchstellen erhält, die einen stabilen Ausfall bzw. einen kontrollierten Ausfall des Vielschichtbauelements begünstigen. Zusätzliche Prozesss- bzw. Fertigungsschritte zum Einbringen von Sollbruchstellen in das Bauelement können somit entfallen. Aus herstellungstechnischer Perspektive wird die Anzahl der Sollbruchstellen allein schon durch die Höhe des Vielschichtbauelements eingestellt, da eine bestimmte Höhe des Vielschichtbauelements eine Anzahl von Vielschichtsegmentgrenzen und somit Sollbruchbereichen impliziert.

Der Sollbruchbereich spricht bei bestimmten Zugbelastungen an, wobei er eine parallel zu den keramischen Schichten bzw. Elektrodenschichten verlaufenden Riss bildet. Da somit mittels des Risses das Dielektrikum in Richtung zwischen zwei Innenelektroden nicht gänzlich durchbrochen wird, kann ein durch bestimmte Zugbelastungen verursachter Kurzschluss zwischen zwei durch übereinander angeordnete Innenelektrodenschichten getragene elektrische Pole des Vielschichtbauelements vermieden werden.

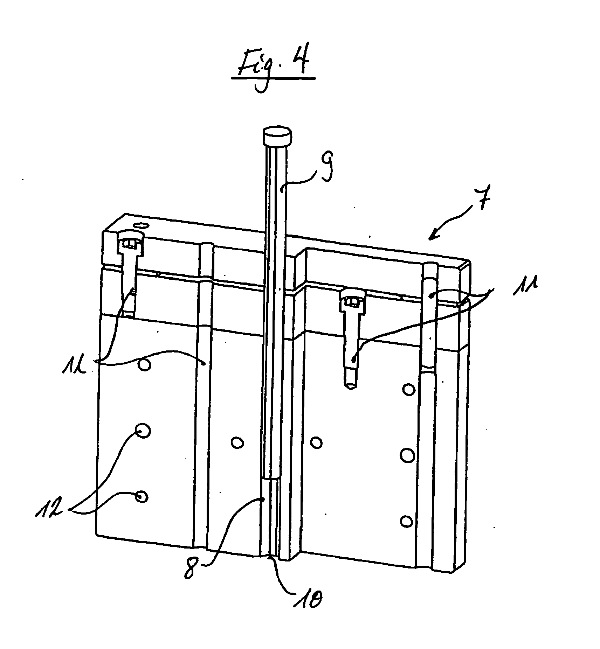

Figuren 4 bis 6 zeigen unterschiedliche Perspektiven eines vorzugsweise massiven, metallischen Blocks 7, in dem Vielschichtsegmente in einer Kaverne 8 mittels eines Stanzwerkzeugs 9 miteinander zum einem Vielschichtbauelement 1 verpresst werden.

Zur Veranschaulichung zeigt Figur 4 einen als ausgeschnitten dargestellten Teil eines vorzugsweise massiven und metallischen Blocks 7 in einer perspektivischen Ansicht.

Der Block hat vorzugsweise folgende Maße: Breite = 130 bis 170 mm, Höhe = 115 bis 155 mm, Tiefe = 30 bis 70 mm. Mittig und vertikal durch den Block 7 verläuft eine Kaverne 8, welche als Bohrung realisiert ist. Die Kaverne weist bodenseitig eine Öffnung 10 auf, welche die Einführung eines nicht dargestellten Pressstifts ermöglicht, der gegen ein in der Kaverne als eingeführt dargestelltes Stanzwerkzeug 9 schiebt. Die Kaverne hat einen inneren lichten Durchmesser der so bemessen ist, dass ein Vielschichtsegment zusammen mit dem das Vielschichtsegment transportierenden und umgreifenden Transportmittel bzw. Stanzwerkzeug in die Kaverne eingeführt werden kann.

Zwischen dem von unten eingeschobenen Pressstift und dem von oben eingeführten Stanzwerkzeug angeordnete Vielschichtsegmente werden miteinander verpresst.

Der Verpressblock 7 weist nach einer Ausführungsform mehrere Teile auf, die über Passstifte positioniert und mit Schrauben gesichert werden. Der Verpressblock kann aber auch einstückig, d.h. aus einem Guss, gefertigt sein.

Vorzugsweise ist der Verpressblock aus Stahl gefertigt, wobei andere Werkstoffe wie beispielsweise Keramik, Sinterwerkstoffe oder andere Hartmetalle verwendet werden können.

Der Verpressblock 7 weist mehrere vertikal verlaufende Bohrungen 11 auf, die nach einer Ausführungsform der Befestigung des Blocks 7 mittels Schrauben oder anderen Befestigungsmitteln mit einem weiteren Gegenstand, beispielsweise ein weiteres Gehäuse, dienen. Auch werden horizontale Befestigungsbohrungen 12 gezeigt. Mittels geeigneter Befestigungsmittel, wie z.B. Schrauben, dienen die horizontalen Befestigungsbohrungen 12 der Zusammenführung ggf. mehrerer Teile des Blocks (von denen anhand dieser Figur nur ein Teil gezeigt wird) zu einer Blockeinheit.

Gemäß einer vorteilhaften Ausführungsform werden Heizelemente zur Beheizung des Verpressblocks in die vertikal verlaufenden Bohrungen 11 eingeführt. Die Heizelemente können als sich erwärmende Widerstandsdrähte realisiert sein. Die Heizelemente können zusammen mit einem Befestigungselement, falls die Bohrungen 11 auch zur Befestigung des Verpressblocks verwendet werden, in den Bohrungen 11 enthalten sein.

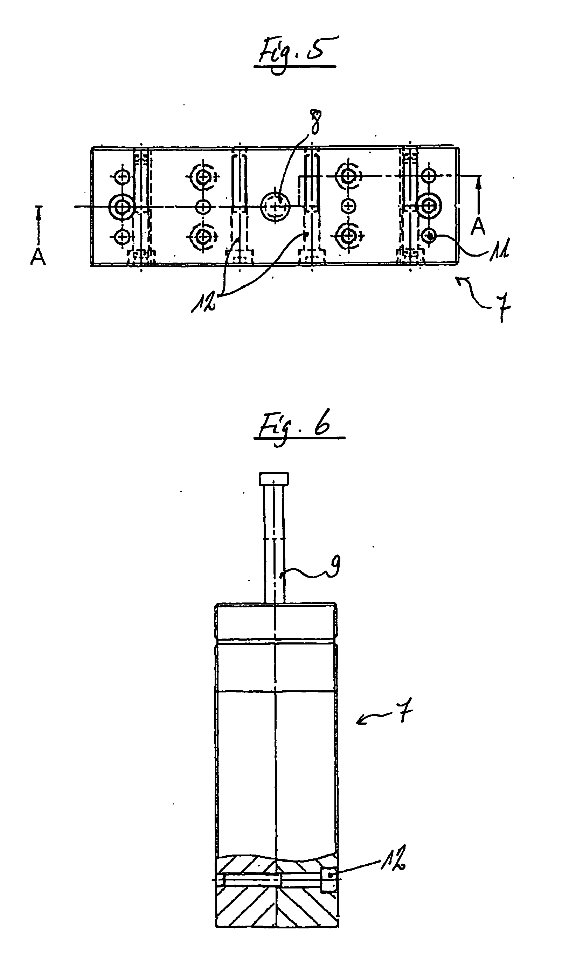

Figur 5 ist eine Draufsicht auf den nur teilweise in Figur 4 perspektivisch dargestellten Block 7. Oberseitig und mittig im Block angeordnet wird eine Öffnung 13 der Kaverne 8 gezeigt. Auch wird die Schnittlinie A - A gezeigt, auf deren einen Seite ein Teil des gesamten Blocks mittels der vorhergehenden Figur gezeigt wurde. Es wird der seitliche Verlauf der horizontalen Befestigungsbohrungen 12 sowie Öffnungen der vertikalen Bohrungen 11 gezeigt.

Figur 6 ist eine Seitenansicht auf den Block 7. Oberseitig ist das teilweise eingeführte Stanzwerkzeug 9 dargestellt. Unterseitig wird der seitliche Verlauf einer Befestigungsbohrung 12 gezeigt.

### Bezugszeichenliste

- 1: Vielschichtbauelement
- 2: keramische Schicht
- 3: Elektrodenschicht
- 4: Vielschichtsegment
- 5: Sollbruchstelle
- 6: Außenkontakt
- 7: massiver Block
- 8: Kaverne
- 9: Stanzwerkzeug
- 10: Bodenseitige Öffnung der Kaverne
- 11: vertikale Befestigungsbohrung
- 12: horizontale Bohrung
- 13: Oberseitige Öffnung der Kaverne

- A - A: Schnittlinie

## Patentansprüche

1. Verfahren zur Herstellung eines keramischen Vielschichtbauelements (1), bei dem
- mehrere keramische Vielschichtsegmente (4) in einem grünen Zustand hergestellt werden, welche jeweils einen Stapel von mehreren miteinander verpressten keramischen Schichten (2) aufweisen,
- anschließend die Vielschichtsegmente miteinander zu einem noch grünen Vielschichtbauelement verpresst werden und
- das noch grüne Vielschichtbauelement anschließend gesintert wird.

2. Verfahren nach Anspruch 1, bei dem zur Herstellung der Vielschichtsegmente (4) mehrere jeweils ein organisches Bindemittel enthaltende keramische Folien miteinander zu einem Folienstapel verpresst werden.

3. Verfahren nach Anspruch 2, bei dem die Temperatur, bei der die keramischen Folien miteinander verpresst werden, niedriger ist, als die Temperatur, bei der die Vielschichtsegmente (4) miteinander verpresst werden.

4. Verfahren nach einem der Ansprüche 2 oder 3, bei dem die Bindewirkung des organischen Bindemittels während des Verpressens der Vielschichtsegmente (4) sich von seiner Bindewirkung während des Verpressens der keramischen Folien unterscheidet.

5. Verfahren nach einem der vorhergehenden Ansprüche, bei dem während des Verpressens der Vielschichtsegmente (4) die darin enthaltenen keramischen Schichten (2) im grünen Zustand vorliegen.

6. Verfahren nach einem der Ansprüche 2 bis 5, bei dem die Temperatur, bei der die keramischen Folien miteinander verpresst werden, höchstens um 25% von der Raumtemperatur abweicht und die Temperatur, bei der die Vielschichtsegmente (4) miteinander verpresst werden, zwischen 75°C und 95°C liegt.

7. Verfahren nach einem der vorhergehenden Ansprüche, bei dem durch Einstellung der Temperatur, bei der die Vielschichtsegmente (4) miteinander verpresst werden, eine Zugfestigkeit des Grenzbereichs zwischen den Vielschichtsegmenten im fertigen Vielschichtbauelement bestimmt wird, die ihm eine Funktion als Sollbruchbereich verleiht.

8. Verfahren nach einem der vorhergehenden Ansprüche, bei dem durch Einstellung der beim Verpressen der Vielschichtsegmente (4) angewandten Presskraft eine Zugfestigkeit des Grenzbereichs zwischen den Vielschichtsegmenten im fertigen Vielschichtbauelement bestimmt wird, die ihm eine Funktion als Sollbruchbereich verleiht.

9. Verfahren nach einem der vorhergehenden Ansprüche, bei dem durch Einstellung der Dauer des Verpressens der Vielschichtsegmente (4) eine Zugfestigkeit des Grenzbereichs zwischen den Vielschichtsegmenten im fertigen Vielschichtbauelement bestimmt wird, die ihm eine Funktion als Sollbruchbereich verleiht.

10. Verfahren nach einem der Ansprüche 2 bis 9, bei dem die Vielschichtsegmente (4) mittels eines Schneidwerkzeuges (9) vom Folienstapel abgetrennt werden.

11. Verfahren nach einem der Ansprüche 1 bis 10, bei dem Vielschichtsegmente eine der folgenden Umrissformen aufweisen: gekrümmt, kreisförmig mit abgeflachten Abschnitten, kreisförmig, oval.

12. Verfahren nach einem der Ansprüche 10 oder 11, bei dem das Schneidwerkzeug (9) die abgetrennten Vielschichtsegmente (4) zum Verpressen in eine Kaverne (8) weitertransportiert.

13. Verfahren nach Anspruch 12, bei dem als Schneidwerkzeug (9) ein Stanzwerkzeug verwendet wird und die Vielschichtsegmente (4) dadurch miteinander verpresst werden, dass das Stanzwerkzeug (9) auf die Stirnfläche des Vielschichtsegments (4) drückt, das zuletzt in die Kaverne eingeführt wurde.

14. Vielschichtbauelement (1), aufweisend
- einen Stapel von übereinander angeordneten keramischen Schichten (2) und Elektrodenschichten (3), **dadurch gekennzeichnet, dass**
- ein parallel zu den keramischen Schichten verlaufender Sollbruchbereich (5) reduzierter Zugfestigkeit zwischen direkt aneinander angrenzenden benachbarten keramischen Schichten sowie in Teilen der direkt aneinander angrenzenden benachbarten keramischen Schichten lokalisiert ist.

15. Vielschichtbauelement (1) nach Anspruch 14, das mehrere übereinander gestapelte Vielschichtsegmente (4) aufweist, welche jeweils mehrere keramische Schichten (2) und Elektrodenschichten (3) aufweisen, wobei ein Sollbruchbereich (5) zwischen benachbarten Vielschichtsegmenten verläuft und teilweise in ihnen enthalten ist.

## Claims

1. Method for producing a ceramic multi-layer component (1), in which method
- a plurality of ceramic multi-layer segments (4) each comprising a stack of a plurality of ceramic layers (2) pressed together are produced in a green state,
- then, the multi-layer segments are pressed together to form a still green multi-layer component, and
- the still green multi-layer component is then sintered.

2. Method according to Claim 1, wherein a plurality of ceramic films each containing an organic binder are pressed together to form a film stack for producing the multi-layer segments (4).

3. Method according to Claim 2, wherein the temperature at which the ceramic films are pressed together is lower than the temperature at which the multi-layer segments (4) are pressed together.

4. Method according to either of Claims 2 and 3, wherein the binding effect of the organic binder during the pressing of the multi-layer segments (4) differs from the binding effect thereof during the pressing of the ceramic films.

5. Method according to one of the preceding claims, wherein the ceramic layers (2) present in the multi-layer segments (4) are present in the green state during the pressing of the latter.

6. Method according to one of Claims 2 to 5, wherein the temperature at which the ceramic films are pressed together deviates at most by 25% from room temperature, and the temperature at which the multi-layer segments (4) are pressed together is between 75°C and 95°C.

7. Method according to one of the preceding claims, wherein, by setting the temperature at which the multi-layer segments (4) are pressed together, a tensile strength causing the interface region between the multi-layer segments in the finished multi-layer component to function as a predetermined breaking region is determined for said interface region.

8. Method according to one of the preceding claims, wherein, by setting the pressing force applied during the pressing of the multi-layer segments (4), a tensile strength causing the interface region between the multi-layer segments in the finished multi-layer component to function as a predetermined breaking region is determined for said interface region.

9. Method according to one of the preceding claims, wherein, by setting the duration of the pressing of the multi-layer segments (4), a tensile strength causing the interface region between the multi-layer segments in the finished multi-layer component to function as a predetermined breaking region is determined for said interface region.

10. Method according to one of Claims 2 to 9, wherein the multi-layer segments (4) are separated from the film stack by means of a cutting tool (9).

11. Method according to one of Claims 1 to 10, wherein the multi-layer segments have one of the following contour shapes: curved, circular with flattened portions, circular, oval.

12. Method according to either of Claims 10 and 11, wherein the cutting tool (9) transports the separated multi-layer segments (4) onward into a cavern (8) for pressing.

13. Method according to Claim 12, wherein the cutting tool (9) used is a stamping tool, and the multi-layer segments (4) are pressed together by the stamping tool (9) pressing onto the end face of the multi-layer segment (4) which was last inserted into the cavern.

14. Multi-layer component (1), comprising
- a stack of ceramic layers (2) and electrode layers (3) arranged one above another, **characterized in that**
- a predetermined breaking region (5) of reduced tensile strength running parallel to the ceramic layers is located between neighbouring ceramic layers which directly adjoin one another and in parts of the neighbouring ceramic layers which directly adjoin one another.

15. Multi-layer component (1) according to Claim 14, comprising a plurality of multi-layer segments (4) which are stacked one above another and which each comprise a plurality of ceramic layers (2) and electrode layers (3), wherein a predetermined breaking region (5) runs between neighbouring multi-layer segments and is partially contained therein.

## Revendications

1. Procédé de fabrication d'un élément multicouche (1) en céramique, dans lequel :
- plusieurs segments multicouches (4) en céramique sont fabriqués dans un état vert, lesdits segments comportant respectivement un empilement de plusieurs couches (2) en céramique compressées les unes contre les autres ;
- les segments multicouches sont ensuite compressés les uns contre les autres pour former un élément multicouche encore vert ; et
- l'élément multicouche encore vert est ensuite fritté.

2. Procédé selon la revendication 1, dans lequel plusieurs feuilles en céramique contenant respectivement un moyen de liaison organique sont compressées les unes contre les autres pour former un empilement de feuilles en vue de fabriquer des segments multicouches (4).

3. Procédé selon la revendication 2, dans lequel la température à laquelle les feuilles en céramique sont compressées les unes contre les autres est inférieure à la température à laquelle les segments multicouches (4) sont compressés les uns contre les autres.

4. Procédé selon l'une quelconque des revendications 2 ou 3, dans lequel l'effet liant du moyen de liaison organique pendant la compression des segments multicouches (4) se différencie de son effet liant pendant la compression des feuilles en céramique.

5. Procédé selon l'une quelconque des revendications précédentes, dans lequel les couches en céramique (2) contenues à l'intérieur restent à l'état vert pendant la compression des segments multicouches (4).

6. Procédé selon l'une quelconque des revendications 2 à 5, dans lequel la température à laquelle les feuilles en céramique sont compressées les unes contre les autres s'écarte au maximum de 25 % par rapport à la température ambiante et la température à laquelle les segments multicouches (4) sont compressés les uns contre les autres se situe entre 75°C et 95°C.

7. Procédé selon l'une quelconque des revendications précédentes, dans lequel une résistance à l'étirement de la zone limite située entre les segments multicouches dans l'élément multicouche fini est déterminée par réglage de la température à laquelle les segments multicouches (4) sont compressés les uns contre les autres, lui conférant ainsi une fonction de zone de rupture théorique.

8. Procédé selon l'une quelconque des revendications précédentes, dans lequel une résistance à l'étirement de la zone limite située entre les segments multicouches dans l'élément multicouche fini est déterminée par réglage de la force de pressage appliquée lors de la compression des segments multicouches (4), lui conférant ainsi une fonction de zone de rupture théorique.

9. Procédé selon l'une quelconque des revendications précédentes, dans lequel une résistance à l'étirement de la zone limite située entre les segments multicouches dans l'élément multicouche fini est déterminée par réglage de la durée de compression des segments multicouches (4), lui conférant ainsi une fonction de zone de rupture théorique.

10. Procédé selon l'une quelconque des revendications 2 à 9, dans lequel les segments multicouches (4) sont détachés de l'empilement de feuilles à l'aide d'un outil de coupe (9).

11. Procédé selon l'une quelconque des revendications 1 à 10, dans lequel les segments multicouches présentent une des formes de déchirure suivantes : incurvée, circulaire avec des sections aplanies, circulaire, ovale.

12. Procédé selon l'une quelconque des revendications 10 ou 11, dans lequel l'outil de coupe (9) poursuit le transport des segments multicouches (4) détachés pour les compresser dans une caverne (8).

13. Procédé selon la revendication 12, dans lequel l'outil de coupe (9) utilisé est un outil d'estampage et dans lequel les segments multicouches (4) sont compressés les uns contre les autres en appuyant l'outil d'estampage (9) sur la surface avant du segment multicouche (4) une fois celui-ci introduit dans la caverne.

14. Élément multicouche (1), comportant un empilement de couches en céramique (2) et de couches d'électrode (3) superposées, **caractérisé en ce qu'**une zone de rupture théorique (5) présentant une résistance à l'étirement réduite et s'étendant parallèlement aux couches en céramique est localisée entre les couches en céramique connexes directement voisines ainsi que dans les parties des couches en céramique connexes directement voisines.

15. Élément multicouche (1) selon la revendication 14, comportant plusieurs segments multicouches (4) empilés les uns au-dessus des autres comportant respectivement plusieurs couches en céramique (2) et plusieurs couches d'électrode (3), une zone de rupture théorique (5) s'étendant entre les segments multicouches voisins et y étant en partie intégrée.
